# EUROPEAN PATENT APPLICATION

(11) **EP 4 550 949 A1**
(43) Date of publication of application: **07.05.2025**
(21) Application number: 23831432.2
(22) Date of filing: 27.06.2023
(51) Int. Cl.: H05K 3/38, H05K 1/03

(54) **WIRING BOARD AND PACKAGE STRUCTURE USING SAME**

(30) Priority: 29.06.2022 JP 2022105078
(71) Applicant: Kyocera Corporation, Kyoto-shi, Kyoto 612-8501 (JP)
(72) Inventor: YUGAWA, Hidetoshi, Kyoto-shi, Kyoto 612-8501 (JP)
(74) Representative: Viering, Jentschura & Partner mbB Patent- und Rechtsanwälte
(86) International application number: PCT/JP2023/023741
(87) International publication number: WO 2024/004992

(57) **Abstract**

A wiring board according to the present disclosure includes a first insulation layer including a first surface, and an electrical conductor layer located on the first surface. The first insulation layer includes an insulating resin, and a plurality of insulating particles dispersed in the insulating resin. The plurality of insulating particles include a first insulating particle including a first region exposed from the insulating resin on the first surface and a second region other than the first region when the first surface is viewed in a top surface view. The electrical conductor layer is located on a surface of the first region and a surface of the insulating resin and is not located below the first region and between the second region and the insulating resin.

## Description

### TECHNICAL FIELD

The present invention relates to a wiring board and a mounting structure using the wiring board.

### BACKGROUND OF INVENTION

In a known insulation layer included in a wiring board, for example, as described in Patent Document 1, an inorganic filler (insulating particles) such as silica or alumina is dispersed for the purpose of lowering a coefficient of thermal expansion of the insulation layer. As described in Patent Document 1, a part of the inorganic filler may be exposed from a surface of the insulation layer.

### CITATION LIST

### PATENT LITERATURE

Patent Document 1: JP 2022-30289 A

### SUMMARY

### SOLUTION TO PROBLEM

A wiring board according to the present disclosure includes a first insulation layer including a first surface, and an electrical conductor layer located on the first surface. The first insulation layer includes an insulating resin, and a plurality of insulating particles dispersed in the insulating resin. The plurality of insulating particles includes a first insulating particle including a first region exposed from the insulating resin on the first surface and a second region other than the first region when the first surface is viewed in a top surface view. The electrical conductor layer is located on a surface of the first region and a surface of the insulating resin and is not located below the first region and between the second region and the insulating resin.

A mounting structure according to the present disclosure includes the wiring board described above, and an electronic component located at a mounting region of the wiring board.

### BRIEF DESCRIPTION OF THE DRAWINGS

FIG. 1 is a cross-sectional view illustrating a wiring board according to an embodiment of the present disclosure.
FIG. 2 is an enlarged cross-sectional view for explaining a region X (main portion) illustrated in FIG. 1.
FIG. 3 is an enlarged cross-sectional view for explaining another main portion of the wiring board according to the embodiment of the present disclosure.
FIG. 4 is an explanatory diagram for explaining the embodiment of a method of forming an electrical conductor layer on a first surface of a first insulation layer in the wiring board according to the embodiment of the present disclosure.

### DESCRIPTION OF EMBODIMENTS

An electrical conductor layer is generally located on a surface of an insulation layer. When an inorganic filler exposed from the surface of the insulation layer is present, as described in Patent Document 1, the electrical conductor layer is also present in a gap between the insulation layer and a portion embedded in the insulation layer in the exposed inorganic filler. Adhesion between the inorganic filler and the electrical conductor layer is weak, and when the electrical conductor layer is present on the inorganic filler, swelling or peeling of the electrical conductor layer may occur. Therefore, there is a demand for a wiring board having excellent adhesiveness between the insulation layer and the electrical conductor layer on a surface of the insulation layer in which insulating particles are dispersed.

The wiring board according to the present disclosure has a configuration as described in the section of "SOLUTION TO PROBLEM" described above, and thus has excellent adhesiveness between the insulation layer and the electrical conductor layer on the surface of the insulation layer in which the insulating particles are dispersed.

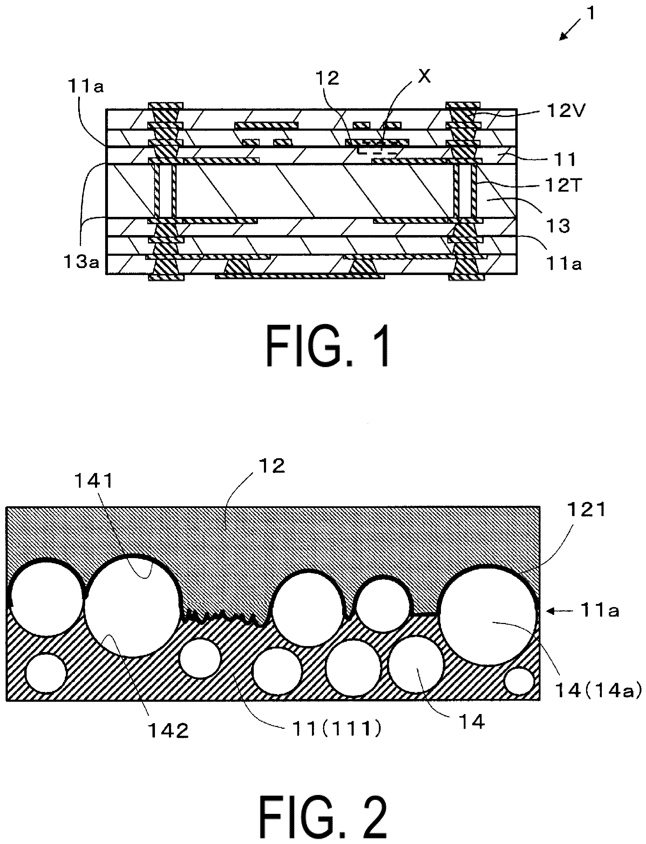

In an embodiment of the present disclosure, the wiring board will be described based on FIGs. 1 to 3. As illustrated in FIG. 1, in the embodiment, a wiring board 1 includes a first insulation layer 11, a second insulation layer 13, and an electrical conductor layer 12. FIG. 1 is a cross-sectional view illustrating the wiring board 1 according to the embodiment.

In the wiring board 1 according to the embodiment, the first insulation layer 11 corresponds to a build-up insulation layer as illustrated in FIG. 1. As illustrated in FIG. 2, the first insulation layer 11 has a structure in which insulating particles 14 are dispersed. FIG. 2 is an enlarged cross-sectional view for explaining a region X (main portion) illustrated in FIG. 1. The insulation layer 11 is not particularly limited as long as it is made of an insulating resin 111. Examples of the insulating resin 111 include an epoxy resin, a bismaleimide-triazine resin, a polyimide resin, a polyphenylene ether resin, and a liquid crystal polymer. Only one type of insulating resin 111 may be used, or two or more types may be used in combination.

Although not illustrated, the first insulation layer 11 may further contain a reinforcing material. Examples of the reinforcing material include insulation fabric materials such as glass fiber, glass non-woven fabric, aramid non-woven fabric, aramid fiber, and polyester fiber. Two or more types of reinforcing materials may be used in combination. The thickness of the first insulation layer 11 is not particularly limited, and is, for example, 2 µm or more and 100 µm or less.

The plurality of insulating particles 14 dispersed in the first insulation layer 11 have a function of reducing a thermal expansion coefficient of the first insulation layer 11. The insulating particles 14 are not limited, and examples include inorganic insulation fillers such as silica, alumina, barium sulfate, talc, clay, glass, calcium carbonate, and titanium oxide. Only one type of insulating particle 14 may be used, or two or more types may be used in combination.

The average particle diameter of the insulating particles 14 is not limited. The insulating particles 14 may include an average particle diameter of, for example, 0.1 µm or more and 2 µm or less, or 1 µm or less. The filling ratio of the insulating particles 14 in the first insulation layer 11 is not limited. In order to sufficiently reduce the thermal expansion coefficient of the first insulation layer 11, the filling ratio of the insulating particles 14 in the first insulation layer 11 may be 50 vol% or more and 90 vol% or less.

When the filling ratio of insulating particles 14 is 50 vol% or more and 90 vol% or less, a contact portion between the electrical conductor layer 12 (seed layer 121) described later and the insulating particles 14 (second insulating particles 14b described later) is increased. As a result, a portion including a non-crystalline structure 16 to be described later increases, and the electrical conductor layer 12 (seed layer 121) and the insulating particles 14 can be more strongly adhered to each other. The average particle diameter of the insulating particles 14 may be calculated, for example, by processing an image captured by an electron microscope of the insulating particles 14 within a predetermined range. The filling ratio may be detected by energy dispersive X-ray analysis.

Some of the insulating particles 14 are first insulating particles 14a. As illustrated in FIG. 2, the first insulating particles 14a each include a first region 141 exposed from the insulating resin 111 on a first surface 11a of the first insulation layer 11 and a second region 142 other than the first region 141.

An apex portion of the first region 141 is located farther from the second insulation layer 13 than the insulating resin 111 closest to the first region 141. The first surface 11a of the first insulation layer 11 corresponds to a main surface farther from a center portion in a thickness direction of the wiring board 1. In FIG. 1, the first surface 11a of the first insulation layer 11 corresponds to a main surface farther from the second insulation layer 13 described later.

As illustrated in FIG. 1, the electrical conductor layer 12 is located on the first surface 11a of the first insulation layer 11. As illustrated in FIG. 2, on the first surface 11a of the first insulation layer 11, the electrical conductor layer 12 is located on the surfaces of the first region 141 of the first insulating particles 14a and the insulating resin 111.

The electrical conductor layer 12 is not limited as long as it is an electrical conductor. Examples of the conductor include metals such as copper. The electrical conductor layer 12 is made by, for example, metal plating, specifically, such as copper plating. The thickness of the electrical conductor layer 12 is not particularly limited, and is, for example, at the thickest portion, 2 µm or more and 50 µm or less.

As illustrated in FIG. 2, the electrical conductor layer 12 may include a seed layer 121 that covers the surfaces of the first region 141 of the first insulating particles 14a and the insulating resin 111. The seed layer 121 is formed for the purpose of improving the adhesiveness of the electrical conductor layer 12 or as a base metal for conduction when the electrical conductor layer 12 is formed on an insulator by electrolytic plating. The seed layer 121 is formed by, for example, a transition metal of any of the groups 4, 5, 6, and 10 in the periodic table, such as titanium, nickel, or chromium, or an alloy containing any of these transition metals, such as nichrome. The thickness of the seed layer 121 is not particularly limited, and is, for example, 1 nm or more and 100 nm or less.

Via-hole electrical conductors 12V are located for electrically connecting the upper and lower surfaces of the laminated first insulation layer 11. The via-hole electrical conductors 12V are located in via-holes penetrating the upper and lower surfaces of the first insulation layer 11. The via-hole electrical conductor 12V is not limited as long as it is a metal (electrical conductor), such as copper. As illustrated in FIG. 1, the via-hole electrical conductors 12V may be made to fill the via-holes or may be formed only on the inner wall surface of the via-holes. The via-hole electrical conductors 12V are connected to the electrical conductor layer 12 located on the surface of the first insulation layer 11.

In the wiring board 1 according to the embodiment, the electrical conductor layer 12 is not located below the first region 141 of the first insulating particles 14a, and is not located between the second region 142 of the first insulating particles 14a and the insulating resin 111. The electrical conductor layer 12 not being located below the first region 141 of the first insulating particles 14a means, in other words, a state in which the electrical conductor layer 12 is not present at a location overlapping the first region 141 in a top perspective view except for a region in which the electrical conductor layer 12 and the first region 141 are in direct contact with each other. That is, the electrical conductor layer 12 is not located below the first insulating particles 14a (on the center portion side of the wiring board 1 in the thickness direction).

When the electrical conductor layer 12 is located below the first region 141 of the first insulating particles 14a, the electrical conductor layer 12 may thermally expand under a high temperature condition, for example, and the electrical conductor layer 12 above the first insulating particles 14a may be pushed up via the first insulating particles 14a and thus cause swelling. When the electrical conductor layer 12 is located between the second region 142 of the first insulating particles 14a and the insulating resin 111, the first insulating particles 14a easily become separated from the insulating resin 111. Thus, swelling or peeling of the electrical conductor layer 12 may occur. Therefore, the wiring board 1 according to the embodiment in which the electrical conductor layer 12 is not located below the first region 141 of the first insulating particles 14a and between the second region 142 of the first insulating particles 14a and the insulating resin 111 has excellent adhesiveness between the first insulation layer 11 and the electrical conductor layer 12.

As illustrated in FIG. 1, in the wiring board 1 according to the embodiment, the second insulation layer 13 is located substantially at the center in the thickness direction of the wiring board 1. In the wiring board 1 according to the embodiment, the second insulation layer 13 corresponds to a core insulation layer as illustrated in FIG. 1. To be specific, in the wiring board 1 according to the embodiment, the first insulation layer 11 is located on each of two second surfaces 13a of the second insulation layer 13. The second surface 13a of the second insulation layer 13 corresponds to a main surface of the second insulation layer 13.

Similarly to the first insulation layer 11, the second insulation layer 13 is not particularly limited as long as it is the insulating resin 111. Examples of the insulating resin 111 include an epoxy resin, a bismaleimide-triazine resin, a polyimide resin, a polyphenylene ether resin, and a liquid crystal polymer. Only one type of insulating resin 111 may be used, or two or more types may be used in combination. The insulating resin 111 included in the second insulation layer 13 may be the same as or different from the insulating resin 111 included in the first insulation layer 11. The thickness of the second insulation layer 13 is not particularly limited, and is, for example, 0.04 mm or more and 3 mm or less.

Although not illustrated, the second insulation layer 13 may further include a reinforcing material, the insulating particles 14, and the like. Examples of the reinforcing material include insulation fabric materials such as glass fiber, glass non-woven fabric, aramid non-woven fabric, aramid fiber, and polyester fiber. Two or more types of reinforcing materials may be used in combination. As described above, examples of the insulating particle 14 include inorganic insulation fillers such as silica, alumina, barium sulfate, talc, clay, glass, calcium carbonate, and titanium oxide. Only one type of insulating particle 14 may be used, or two or more types may be used in combination.

A through-hole electrical conductor 12T is located in the second insulation layer 13 in order to electrically connect the upper and lower surfaces of the second insulation layer 13. The through-hole electrical conductor 12T is located in a through hole penetrating through the upper and lower surfaces of the second insulation layer 13. The through-hole electrical conductor 12T is not limited as long as it is a metal (electrical conductor) such as copper. As illustrated in FIG. 1, the through-hole electrical conductor 12T may be formed only on the inner wall surface of the through hole or may be made to fill the through hole. The through-hole electrical conductor 12T is connected to the electrical conductor layer 12 located on the upper and lower surfaces of the second insulation layer 13.

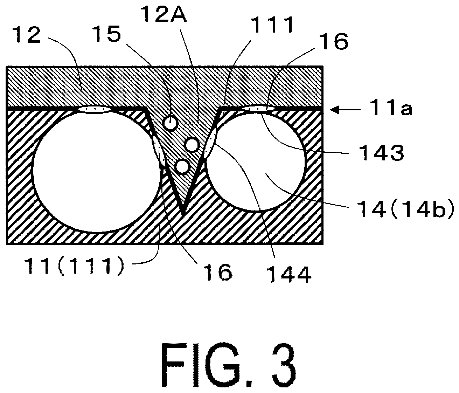

As illustrated in FIG. 3, in the wiring board 1 according to the embodiment, the electrical conductor layer 12 may include a protruding portion 12A protruding into the insulating resin 111. That is, the protruding portion 12A is located in a direction from the first surface 11a to a side of the second insulation layer 13. FIG. 3 is an enlarged cross-sectional view for explaining another main portion of the wiring board 1 according to the embodiment. When the electrical conductor layer 12 includes the protruding portion 12A, a contact area between the electrical conductor layer 12 and the insulating resin 111 increases, and thus the electrical conductor layer 12 is less likely to peel off from the first insulation layer 11. The depth of the protruding portion 12A from the first surface 11a is not limited and may be, for example, 30 nm or more and 1 µm or less at the deepest portion, or 50 nm or more and 500 nm or less. The protruding portion 12A having a smaller depth is advantageous in terms of forming a fine wiring.

As illustrated in FIG. 3, the protruding portion 12A may include voids 15. When the protruding portion 12A includes the voids 15, a buffering effect can be provided. As a result, stress generated in the electrical conductor layer 12 can be alleviated. The proportion of the voids 15 may be, for example, 10 vol% or more and 60 vol% or less relative to a volume of the protruding portion 12A. The proportion of the voids 15 can be calculated by performing cross-sectional observation image processing from a plurality of directions with an electron microscope. In particular, since the voids 15 are fine, it is preferable to calculate the proportion of the voids 15 from a picture taken by a transmission electron microscope.

As illustrated in FIG. 3, in the wiring board 1 according to the embodiment, a contact portion between the electrical conductor layer 12 (seed layer 121) and the insulating particles 14 may include the non-crystalline structure 16. The non-crystalline structure 16 is a structure not including a regular array structure like a crystal. Specifically, in the contact portion between the electrical conductor layer 12 (seed layer 121) and the insulating particles 14, the non-crystal of the electrical conductor layer 12 (seed layer 121) and the non-crystal of the insulating particles 14 are mixed with each other. Due to the presence of the non-crystalline structure 16, the electrical conductor layer 12 (seed layer 121) and the insulating particles 14 are more strongly adhered to each other.

As illustrated in FIG. 3, when the first surface 11a is viewed in a cross-sectional view, in the wiring board 1 according to the embodiment, the plurality of insulating particles 14 may include second insulating particles 14b including a third region 143 in contact with the electrical conductor layer 12 (seed layer 121) and a fourth region 144 in contact with the protruding portion 12A (seed layer 121) on the first surface 11a. In the case of including such a structure, a portion of the second insulating particles 14b between the third region 143 and the fourth region 144 may be coated with the insulating resin 111. When the portion between the third region 143 and the fourth region 144 is coated with the insulating resin 111, the insulating resin 111 can alleviate thermal stress generated by the difference between the thermal expansion coefficient of the electrical conductor layer 12 and the thermal expansion coefficient of the second insulating particles 14b. As a result, the adhesiveness between the electrical conductor layer 12 and second insulating particles 14b can be further improved.

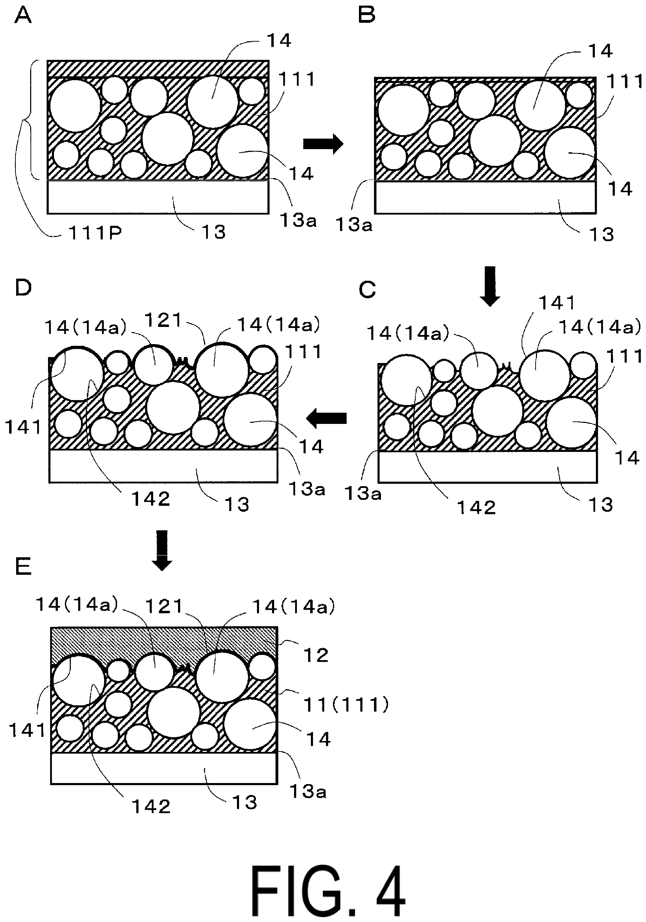

An embodiment of a method of forming the electrical conductor layer 12 on the first surface 11a of the first insulation layer 11 will be described based on FIGs. 4A to 4E. A to E in FIG. 4 are explanatory diagrams for explaining the embodiment of the method of forming the electrical conductor layer 12 on the first surface 11a of the first insulation layer 11 in the wiring board 1 according to the embodiment. In A to E in FIG. 4, the method of forming the electrical conductor layer 12 on the first surface 11a of first insulation layer 11 located on an upper surface (second surface 13a) of the second insulation layer 13 will be described as an example. In A to E in FIG. 4, a portion in which the electrical conductor layer 12 is not present on the second surface 13a of the second insulation layer 13 is described as an example, and the electrical conductor layer 12 is also located on the second surface 13a of the second insulation layer 13.

First, as illustrated in A in FIG. 4, an insulation sheet 111P made of the insulating resin 111 in which the plurality of insulating particles 14 are dispersed is layered on the second surface 13a of the second insulation layer 13. The layering method may be, for example, thermocompression bonding of the insulation sheet 111P to the second surface 13a under vacuum. At this time, the insulating particles 14 are unevenly distributed on a side of the second insulation layer 13, and a portion (layer) having a high proportion of the insulating resin 111 is formed near the surface on the opposite side. The thickness of the portion having a high proportion of the insulating resin 111 is, for example, approximately 10 nm or more and 100 µm or less.

Next, as illustrated in B in FIG. 4, the obtained laminate body is subjected to a plasma treatment to reduce the thickness of the portion having a high proportion of the insulating resin 111. To be specific, the plasma treatment may be performed such that the thickness becomes approximately 100 nm. After the thickness of the portion where the proportion of the insulating resin 111 is high is reduced, a permanganate acid solution treatment is performed. The permanganate acid solution treatment may be performed, for example, at a temperature of 40°C or higher and 60°C or lower for a period of 30 seconds or longer and 10 minutes or shorter. In this way, as illustrated in C in FIG. 4, some of the insulating particles 14 are partially exposed from the surface of the insulating resin 111. The insulating particles 14 partially exposed from the surfaces of the insulating resin 111 correspond to the first insulating particles 14a. In the first insulating particles 14a, portions exposed from the surface of the insulating resin 111 correspond to the first region 141.

After the permanganate acid solution treatment, the laminate body is again subjected to the plasma treatment. The second plasma treatment is performed to roughen the surface of the insulating resin 111 exposed between the first insulating particles 14a. The seed layer 121 can have an improved adhesive property by performing the second plasma treatment. The second plasma treatment is performed, for example, so that the resin is removed from the surface of the insulating resin 111 exposed between the first insulating particles 14a to a depth approximately 100 nm or more and 300 nm or less.

Next, as illustrated in D in FIG. 4, the seed layer 121 is formed on the surfaces of the first region 141 of the first insulating particles 14a and the surface of the insulating resin 111. The seed layer 121 is, as described above, made of a transition metal of any of the groups 4, 5, 6, and 10 in the periodic table, such as titanium, nickel, or chromium, or an alloy including any of these transition metals, such as nichrome. The method of forming the seed layer 121 is not limited, and examples of the method include sputtering or vapor deposition.

When sputtering is employed, metals forming the seed layer 121 collide with the first region 141 of the first insulating particles 14a and the third region 143 and the fourth region 144 of the second insulating particles 14b exposed from the surface of the insulating resin 111 and generate heat energy. Due to the generated heat energy, the atomic arrangement changes or transitions on the surfaces of the first region 141, the third region 143, and the fourth region 144. As a result, a part of the surfaces of the first region 141, the third region 143, and the fourth region 144 becomes a non-crystalline, and a non-crystalline layer of the insulating particles 14 is formed.

In parallel with the formation of the non-crystalline layer of the insulating particles 14, the seed layer 121 is formed on the surface of the insulating resin 111 and the surfaces of the first region 141, the third region 143, and the fourth region 144. At this time, since the insulating particles 14 are non-crystalline, the metal deposited on the surfaces of the first region 141, the third region 143, and the fourth region 144 becomes non-crystalline in a part of the seed layer 121 (a contact surface with the surfaces of the first region 141, the third region 143, and the fourth region 144), and an non-crystalline layer of the metal is formed. The formation of the non-crystalline layer of the metal reduces the entry of the electrical conductor layer 12 between the insulating resin 111 and the insulating particles 14.

As illustrated in E in FIG. 4, the electrical conductor layer 12 is formed on the surface of the seed layer 121. Specifically, the electrical conductor layer 12 is formed by depositing a metal such as copper through electrolytic plating. The thickness of the electrical conductor layer 12 is as described above, and detailed description thereof will be omitted.

Another insulation sheet 111P made of the insulating resin 111 in which the plurality of insulating particles 14 is dispersed is layered on the upper surface, and the same or similar procedure is repeated to obtain the wiring board 1 in which the desired number of layers are layered.

A mounting structure according to the present disclosure includes the wiring board according to the present disclosure and an electronic component located on a mounting region of the wiring board. Examples of the electronic component include a semiconductor integrated circuit element and an optoelectronic element. The electronic component is connected to the mounting region of the wiring board via solder. The electronic component may be located on both surfaces of the wiring board, or elements may be located on one surface, and, for example, a motherboard and the like may be located on the other surface thereof.

The wiring board of the present disclosure is not limited to the embodiment described above. For example, the wiring board 1 described above includes the second insulation layer 13 which corresponds to a core insulation layer. However, in the wiring board of the present disclosure, the second insulation layer 13 is not an essential member, and is an optional member. Accordingly, the wiring board of the present disclosure may be in the form of a so-called coreless wiring board in which the second insulation layer 13 is not present.

In the above-described wiring board 1, the non-crystalline structure 16 is illustrated only in the vicinity of the protruding portion 12A illustrated in FIG. 3. However, in the wiring board 1 of the present disclosure, the non-crystalline structure 16 can be formed at any contact portion between the electrical conductor layer 12 (seed layer 121) and the insulating particles 14. Therefore, the non-crystalline structure 16 can also be formed in at least a part of the contact portion between the first region 141 of the first insulating particles 14a and the electrical conductor layer 12 (seed layer 121) as illustrated in FIG. 2.

An embodiment of the present disclosure has been described above. However, the invention according to the present disclosure is not limited to the above-described embodiment, and various changes or improvements can be made within the scope of the present disclosure described in (1) and (8) below.
(1) A wiring board according to the present disclosure includes a first insulation layer including a first surface and an electrical conductor layer located on the first surface. The first insulation layer includes an insulating resin, and a plurality of insulating particles dispersed in the insulating resin. The plurality of insulating particles include a first insulating particle including a first region exposed from the insulating resin on the first surface and a second region other than the first region when the first surface is viewed in a top surface view. The electrical conductor layer is located on a surface of the first region and a surface of the insulating resin and is not located below the first region and between the second region and the insulating resin.
   With regard to the embodiment of the present disclosure, the following embodiments (2) to (7) will be further disclosed.
(2) The wiring board according to (1) further includes a second insulation layer including a second surface, and at least one layer of the first insulation layer is located on the second surface.
(3) In the wiring board according to (1) or (2), the electrical conductor layer includes a protruding portion protruding into the insulating resin.
(4) In the wiring board according to (3), the protruding portion includes voids.
(5) In the wiring board according to any one of (1) to (4), a contact portion between the electrical conductor layer and the insulating particles has a non-crystalline structure.
(6) In the wiring board according to any one of (3) to (5), in a cross-sectional view passing through the first surface, the plurality of insulating particles include a second insulating particle including a third region in contact with the electrical conductor layer and a fourth region in contact with the protruding portion on the first surface, and a portion of the second insulating particle between the third region and the fourth region is coated with the insulating resin.
(7) In the wiring board according to any one of (1) to (6), a filling ratio of the insulating particles is 50 vol% or more and 90 vol% or less.

(8) A mounting structure according to the present disclosure includes a wiring board according to any one of (1) to (7) described above, and an electronic component located on a mounting region of the wiring board.

### REFERENCE SIGNS

1 Wiring board
11 First insulation layer
11a First surface
111 Insulating resin
12 Electrical conductor layer
12A Protruding portion
12T Through-hole electrical conductor
12V Via-hole electrical conductor
121 Seed layer (Electrical conductor layer)
13 Second insulation layer
13a Second surface
14 Insulating particle
14a First insulating particle
14b Second insulating particle
141 First region
142 Second region
143 Third region
144 Fourth region
15 Void
16 Non-crystalline structure

## Claims

1. A wiring board, comprising:
a first insulation layer comprising a first surface; and
an electrical conductor layer located on the first surface, wherein
the first insulation layer comprises an insulating resin and a plurality of insulating particles dispersed in the insulating resin,
the plurality of insulating particles comprises a first insulating particle comprising a first region exposed from the insulating resin in the first surface and a second region other than the first region when the first surface is viewed in a top surface view, and
the electrical conductor layer is located on a surface of the first region and a surface of the insulating resin, and is not located below the first region and between the second region and the insulating resin.

2. The wiring board according to claim 1, further comprising:
a second insulation layer comprising a second surface, wherein
at least one layer of the first insulation layer is located on the second surface.

3. The wiring board according to claim 1 or 2, wherein
the electrical conductor layer comprises a protruding portion protruding into the insulating resin.

4. The wiring board according to claim 3, wherein
the protruding portion comprises voids.

5. The wiring board according to any one of claims 1 to 4, wherein
a contact portion between the electrical conductor layer and the insulating particle comprises a non-crystalline structure.

6. The wiring board according to any one of claims 3 to 5, wherein
in a cross-sectional view passing through the first surface, the plurality of insulating particles comprise a second insulating particle comprising a third region in contact with the electrical conductor layer and a fourth region in contact with the protruding portion on the first surface, and
a portion of the second insulating particle between the third region and the fourth region is coated with the insulating resin.

7. The wiring board according to any one of claims 1 to 6, wherein
a filling ratio of the insulating particles is 50 vol% or more and 90 vol% or less.

8. A mounting structure comprising:
the wiring board according to any one of claims 1 to 7; and
an electronic component located at a mounting region of the wiring board.
